# EUROPÄISCHE PATENTANMELDUNG

(11) **EP 1 278 086 A1**
(43) Veröffentlichungstag der Anmeldung: **22.01.2003**
(21) Anmeldenummer: 01440227.5
(22) Anmeldetag: 18.07.2001
(51) Int. Cl.: G02B 6/42, G02B 3/00

(54) **Kugellinse und opto-elektronisches Modul mit derselben**

(71) Anmelder: ALCATEL, 75008 Paris (FR)
(72) Erfinder: Heck, Wolfgang, 70839 Gerlingen (DE); Joerg, Walter, 70439 Stuttgart (DE)
(74) Vertreter: Urlichs, Stefan, Dipl.-Phys.

(57) **Zusammenfassung**

Eine Kugellinse (K) für ein opto-elektronisches Modul weist eine plane Fläche auf, die mit einer Iötbaren Metallbeschichtung (M) versehen ist. Die Kugellinse (K) wird mit ihrer planen, metallisierten Fläche (M) auf ein auf dem Substrat (T) aufgebrachtes Lötpad (P) aufgelötet.

## Beschreibung

Die Erfindung betrifft eine Kugellinse für ein opto-elektronisches Modul und ein solches Modul mit Kugellinse. Desweiteren betrifft die Erfindung ein Verfahren zum Befestigen einer solchen Kugellinse auf einem Substrat des Moduls.

In der Nachrichtenübertragung werden zunehmend optische Übertragungsverfahren eingesetzt. Hierzu werden zuverlässige und kostengünstige opto-elektronische Module benötigt, z.B. als Sender, Empfänger oder Regenerator ("Transceiver").

Aus dem Artikel "Low-Cost/High Volume Laser Modules Using Silicon Optical Bench Technology" von J.W. Osenbach et al., Elektronic Components & Technology Conference 1998, Seiten 581-587, ist ein solches Modul bekannt, daß nach der sogenannten SiOB (Silicon Optical Bench) Technologie hergestellt ist. Es besteht aus einem Silizium-Substrat mit darauf aufgebrachten metallischen Lötpads und Leiterbahnen. Ein Laserchip und eine Photodiode sind auf dem Substrat aufgelötet, während eine Kugellinse mittels sogenanntem AIO-Bonding auf dem Substrat befestigt ist. Unter AIO-Bonding versteht man eine Technik, bei der ein Körper aus Silica (Siliziumoxid, SiO₂) unter hoher Temperatur auf eine auf das Substrat aufgebrachte Aluminiumschicht gepreßt wird. Dadurch entsteht eine chemische Verbindung zwischen dem SiO₂ und dem AI.

Ein Nachteil des bekannten Moduls besteht darin, daß durch die beim Bonden benötigten hohen Prozeßtemperaturen zu einer Degradation der bereits montierten Halbleiterchips (Laser, Photodiode) führen. Zudem macht es präzise hergestellte V-Nuten zur lagerichtigen Montage der Kugellinse erforderlich.

Bei einem alternativen Befestigungsverfahren wird die Kugellinse aufgeklebt. Dies hat die Nachteile, daß die Klebverbindung mangelnde Langzeitstabilität aufweist und durch Ausgasen flüchtiger Reaktionsprodukte des Klebstoffes die optische Qualität des Moduls vermindert wird.

Aufgabe der Erfindung ist es daher, ein Befestigungsverfahren für eine Kugellinse auf einem optischen Substrat anzugeben, welches die geschilderten Nachteile nicht aufweist. Weitere Aufgaben der Erfindung bestehen darin, eine für derartige Befestigung geeignete Kugellinse und ein elektro-optisches Modul mit einer solchen anzugeben.

Die Aufgabe wird dadurch gelöst, daß die Kugellinse eine plane Fläche aufweist, die mit einer lötbaren Metallbeschichtung versehen ist und daß die Kugellinse mit ihrer planen, metallisierten Fläche auf ein auf dem Substrat aufgebrachtes Lötpad aufgelötet wird.

Vorteile der Erfindung bestehen darin, daß die Montage der Kugellinse sehr zuverlässig ist, daß die Haftung der Linse gegenüber bekannten Verfahren sogar noch verbessert ist, daß durch die Oberflächenspannung des flüssigen Lots beim Löten eine Selbstjustierung eintritt, die zu erhöhter Präzision der Ausrichtung in optischer Achse zum Optohalbleiter-Chip führt, daß Halbleiterchips und Linse simultan aufgelötet werden können, wodurch ein Prozeßschritt gespart wird, daß das Verfahren sich üblichen Prozeßschritten bedient und das erfindungsgemäße opto-elektronische Modul daher äußerst kostengünstig in Serienproduktion hergestellt werden kann.

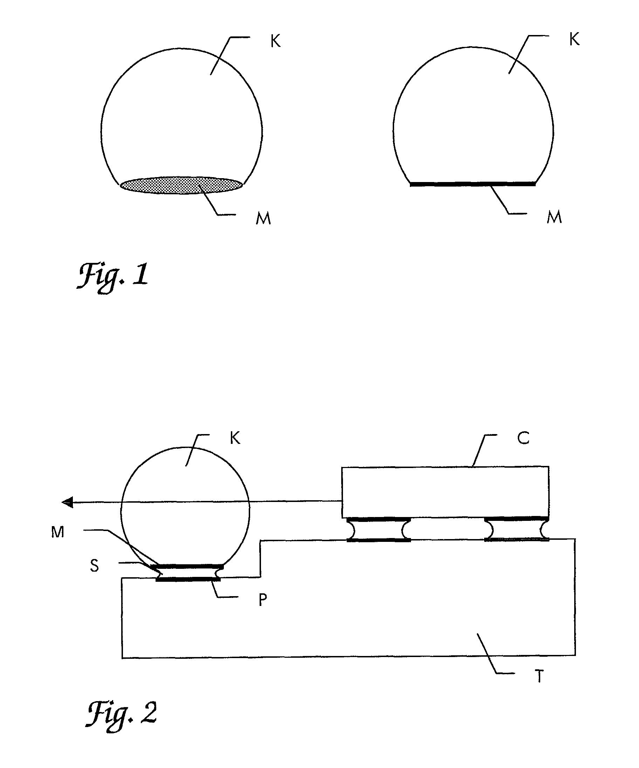

Im folgenden wird die Erfindung anhand der Figuren 1 und 2 in einem Ausführungsbeispiel erläutert. Es zeigt:
- Figur 1:: eine erfindungsgemäße Kugellinse in dreidimensionaler Ansicht und im Schnitt und
- Figur 2:: eine auf einem Substrat aufgelötete Kugellinse.

Ein Grundgedanke der Erfindung besteht darin, eine Linse, vorzugsweise eine Kugellinse, durch Löten auf einem Substrat eines opto-elektronischen Moduls zu befestigen. Dazu wird eine Seite der Linse abgeflacht und mit einer lötfähigen Metallbeschichtung versehen.

Figur 1 zeigt eine erfindungsgemäße Kugellinse K, die eine plane Fläche aufweist. Auf die plane Fläche ist eine lötfähige Metallbeschichtung M aufgebracht. Im linken Teil der Figur ist die Kugellinse in einer dreidimensionalen Ansicht gezeigt, im rechten Teil im Querschnitt durch den Kugelmittelpunkt senkrecht zur Fläche M. Die Kugellinse besteht aus einem Glas wie Silica (Siliziumoxid, SiO₂). Die Metallbeschichtung besteht aus mehreren Metallschichten, zuunterst Titan, darauf wahlweise entweder Gold oder eine Platinschicht und darauf eine Goldschicht. Andere bekannte lötfähige Schichtsysteme sind ebenfalls geeignet.

Zur Herstellung werden eine Vielzahl Kugellinsen in einer Wanne in dichter Packung mittels einer Schablone oder einer Einbettmasse fixiert. Durch Überschleifen wird die plane Fläche hergestellt. Anschließend erfolgt die Metallisierung mit einer lötfähigen Beschichtung. Dazu wird mit einem geeigneten Metallisierungsverfahren wie Sputtern (Kathodenstrahlzerstäubung) oder Aufdampfen ein geeignetes lötfähiges Schichtsystem aufgebracht. Die Metallisierung kann zusätzlich noch galvanisch verstärkt werden.

Figur 2 zeigt ein opto-elektronische Modul, welches ein Substrat T und darauf angeordnet ein Laserchip C und eine Kugellinse K umfaßt. Laserchip C und Kugellinse K sind aufgelötet. Das Substrat besteht aus kristallinem Silizium (Si) und wird nach einem üblichen Verfahren hergestellt. Die Kugellinse K ist in einer Vertiefung auf des Substrats angeordnet. Auf dem Substrat befinden sich Lötpads P ("solder bumps") für Chip C und Linse K sowie gegebenenfalls elektrische Leiterbahnen. Lötpads für Chip C und Linse K werden im selben Prozeßschritt aufgebracht. Die Lichtaustrittsrichtung und optische Achse der Laserchips C ist durch einen Pfeil angedeutet.

Auf die Lötpads P werden Chip C und Linse L aufgelötet. Dazu werden Chip C und Linse K auf die Pads P platziert und mittels Reflow-Löten gleichzeitig verlötet. Durch die Oberflächenspannung erfolgt eine Selbstjustierung der vorplatzierten Bauelemente zueinander. Dadurch kann auf Justagehilfen auf dem Substrat wie Anschläge, Abstandshalter o.ä. verzichtet werden. Das Lot ist in der Figur mit S bezeichnet.

Figur 2 ist schematische und nicht maßstabsgerechte Prinzipzeichnung zu verstehen, insbesondere hinsichtlich der Vertiefung, in die die Linse eingelötet ist. Tatsächlich kann beispielsweise wie in dem eingangs zitierten Artikel die Vertiefung für die Kugellinse eine in das Substrat geätzte V-Nut sein, in der das Lötpad aufgebracht und die Kugellinse eingelötet ist.

Die Erfindung ist auch nicht auf kugelförmige Linsen beschränkt. Vielmehr können auch andere Linsenformen wie z.B. ovale, konkave, konvexe oder zylinderförmige Linsen nach dem gleichen Prinzip befestigt werden.

Wie vorstehend erläutert, werden nur übliche und wohlbeherrschte Prozeßschritte eingesetzt. Dadurch kann die Befestigung der Linse problemlos in bestehende und qualifizierte Herstellungsprozesse für sogenannte Submounts integriert werden. Zudem hat die Erfindung den Vorteil, daß sie ohne organische Klebstoffe auskommt. Sie hat noch dazu den Vorteil, daß die Auflagefläche der Kugel nicht nur aus einzelnen Punkten besteht wie bei bekannten Bonding-Verfahren. Dadurch wird die Haftung der Linse erheblich verbessert.

## Patentansprüche

1. Linse (K) für ein opto-elektronisches Modul, **dadurch gekennzeichnet, daß** die Linse (K) eine plane Fläche aufweist, die mit einer lötbaren Metallbeschichtung (M) versehen ist.

2. Linse (K) nach Anspruch 1, welche als Kugellinse ausgestaltet ist.

3. Linse (K) nach Anspruch 1, bei der die Metallbeschichtung (M) aus einer oder mehreren gesputterten oder aufgedampften Metallschichten besteht.

4. Opto-elektronisches Modul, enthaltend ein Substrat (T) mit einem oder mehreren darauf angeordneten opto-elektronischen Bauelementen (C) und einer Linse (K), **dadurch gekennzeichnet, daß** die Linse (K) eine plane Fläche aufweist, die mit einer lötbaren Metallbeschichtung (M) versehen ist, und daß die Linse (K) mit ihrer planen, metallisierten Fläche (M) auf ein auf dem Substrat (T) aufgebrachtes Lötpad (P) aufgelötet ist.

5. Opto-elektronisches Modul nach Anspruch 4, bei dem das Substrat (T) aus kristallinem Silizium besteht.

6. Opto-elektronisches Modul nach Anspruch 4, bei dem die Linse (K) in einer Vertiefung in dem Substrat (T) festgelötet ist.

7. Verfahren zum Befestigen einer Linse (K) auf einem Substrat (T), enthalten folgende Schritte:
- Einbringen einer planen Fläche in die Linse (K),
- Metallisieren der planen Fläche mit einer lötbaren Metallbeschichtung (M) und
- Auflöten der Linse mit ihrer planen, metallisierten Fläche (M) auf ein auf dem Substrat (T) aufgebrachtes Lötpad (P).

8. Verfahren nach Anspruch 7, bei dem die Metallbeschichtung (M) aufgesputtert oder aufgedampft wird.
